Europäisches Patentamt

(19) European Patent Office

Office européen des brevets

(11) Publication number: **0 049 276**
**B1**

(12) **EUROPEAN PATENT SPECIFICATION**

(45) Date of publication of patent specification: **30.05.84**

(21) Application number: **81901069.5**

(22) Date of filing: **26.03.81**

(86) International application number:
**PCT/US81/00384**

(87) International publication number:
**WO 81/02958 15.10.81 Gazette 81/24**

(51) Int. Cl.³: **H 04 B 3/54**

(54) **TERMINAL UNIT FOR AUTOMATIC METER READING SYSTEM.**

(30) Priority: **31.03.80 US 135860**

(43) Date of publication of application:
**14.04.82 Bulletin 82/15**

(45) Publication of the grant of the patent:
**30.05.84 Bulletin 84/22**

(84) Designated Contracting States:
**CH DE FR GB LI**

(56) References cited:
**GB-A-1 543 501**
**GB-A-2 004 101**
**US-A-3 622 994**
**US-A-4 008 458**
**US-A-4 012 734**
**US-A-4 161 720**

(73) Proprietor: **GENERAL ELECTRIC COMPANY**
**1 River Road**
**Schenectady New York 12305 (US)**

(72) Inventor: **ROBINSON, Paul Bradford**
**9 Fogg Drive**
**Durham, NH 03824 (US)**
Inventor: **OUELLETTE, Maurice Joseph**
**Oakwood Road**
**North Berwick, ME 03906 (US)**
Inventor: **SCHMIDT, Larry Alan**
**8 Hickory Lane**
**Rochester, NH 03867 (US)**

(74) Representative: **Hughes, Brian Patrick et al**
**Graham Watt & Co. Riverhead**
**Sevenoaks, Kent TN13 2BN (GB)**

## Description

Technical field

The present invention relates to an improved terminal unit for an automatic meter reading system. The invention is especially useful in automatic remote meter reading systems for reading and transmitting utility meter readings from the users premises to a central location for recordation and billing. For instance, the invention is especially useful for reading and transmitting data from electric power meters, or gas meters, or water meters, which measure consumption of those commodities.

Background art

The present invention represents an improvement upon a prior system disclosed in British patent specification 1,543,501, General Electric Company, published on 4 April 1979. In that prior system, a reading control center communicates over voice grade communication lines with a number of section control units, and through the section control units and through electric power lines to individual meter terminal units. US—A—4 161 720, assigned to the present applicant, describes and claims a meter terminal unit for use in the system disclosed in GB—A—1 543 501. The present invention relates particularly to improved meter terminal units for use in such a system. The meter terminal units of the prior system were capable of receiving and immediately carrying out commands relating to load control operations and relating to the transmission of meter readings back to the section control units.

However, it has been determined that it is very desirable to provide for additional command functions in such systems including the transmission of commands to meter terminal units requiring future actions by the meter terminal units at predetermined times as specified by the commands.

Summary of the invention

It is a major object of the present invention to provide an improved terminal unit for an automatic meter reading system which is operable to receive and execute an "execute hence" type of command requiring the terminal unit to carry out the command at a specified future time. The "execute hence" capability is in addition to the ability to carry out commands for immediate execution.

In carrying out the invention there is provided a terminal unit for an automatic meter reading system, said terminal unit being arranged for connection to a power line and comprising means for receiving a command over the power line, decode means responsive to the received command to effect the immediate execution of the function specified by the command in response to recognition of an address assigned to said terminal unit as specified by at least a portion of the contents of the command;

characterized by the provision that said decode means comprises an information processor including means to distinguish between an execute immediate command and an execute hence command and to cause the immediate execution of a command only when that command is recognized as an execute immediate command, and further characterized by the provision that said information processor is operable to effect the execution of the function specified by the command only at a specified future time in response to recognition of the command as an execute hence type of command in combination with recognition of an address assigned to said terminal unit as specified by an address portion of the command, said time or execution being specified by a time field portion of said command.

In the accompanying drawings:

Fig. 1 is a schematic block diagram of an entire system of the type incorporating the present invention.

Fig. 2 is a schematic block diagram showing the major components and interconnections of the meter terminal unit of the present invention.

Fig. 3 is a schematic diagram of a preferred embodiment of the information processor portion of the meter terminal unit of Fig. 2.

Fig. 4 is a schematic diagram illustrating the apparatus and components which are intended to be connected to the information processor of Fig. 3 to receive decoded commands and to operate in response thereto, and to provide data to the information processor for transmission back to the section control unit.

Fig. 5 is a functional block diagram illustrating a system combination of logical component circuits which can be employed for carrying out certain aspects of the invention.

Detailed description of the invention

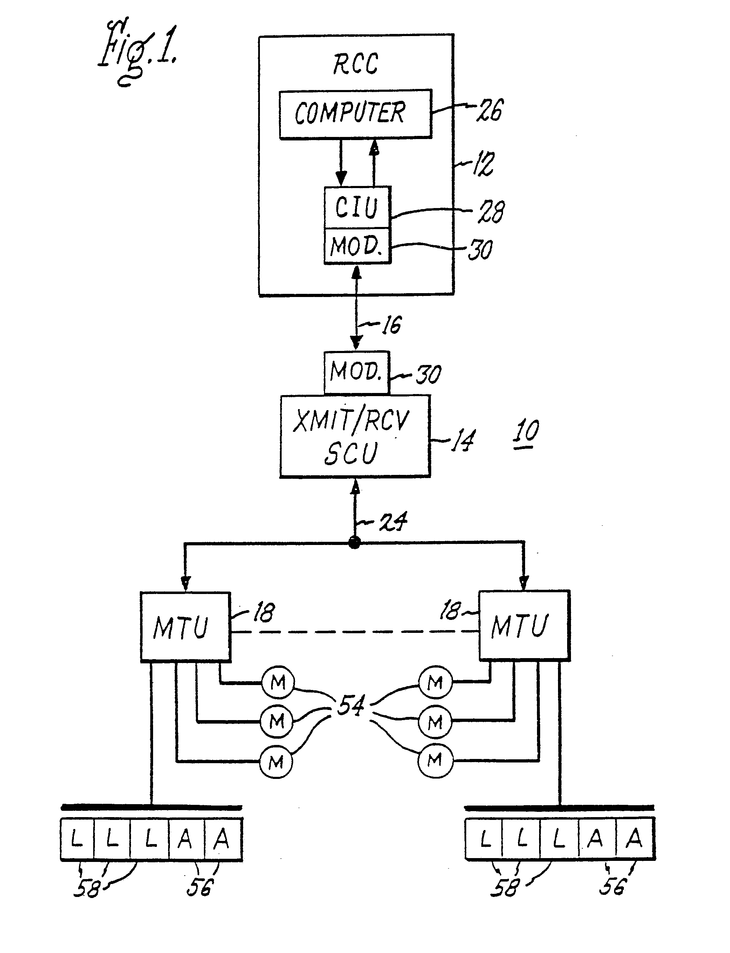

Referring particularly to Fig. 1 of the drawings, there is shown a schematic diagram of a system in which the present invention is particularly useful. The system is generally designated as 10 and includes a reading control center (RCC) 12 which communicates with a section control unit (SCU) 14 over a communication link 16. The section control unit 14 communicates with a plurality of meter terminal units (MTU) 18 over a communication link 24. The communication link 24 is a power line, and preferably consists of an electric power distribution grid. Each meter terminal unit 18 has the capability of reading a plurality of different utility meters by taking readings from meter reading encoders 54. Each terminal unit 18 also has the capability of controlling a number of different loads 58 or alert signal devices 56. Each terminal unit also has the capability for reporting the status of a plurality of devices such as relay contacts (not shown). In the preferred embodiment, each meter terminal unit 18 has the capability for reading three meter encoders 54, controlling three external loads 58, and two alert signalling devices 56; and for reporting the status of up to six external contacts.

The reading control center 12 controls the overall operation of the system. Control center 12 includes a digital computer 26 which communicates with the rest of the system through one or more communications interface units (CIU) 28.

The communications interface unit 28 issues commands and receives data over the communication link 16, which is preferably a voice grade telephone circuit, through a modulator-demodulator circuit (MOD) 30. A similar modulator-demodulator circuit 30 is provided as shown at the section control unit 14 end of the communication link 16.

Preferably, the section control unit 14 is installed at a sub-station of the utility, such as the electric power utility which may be using the system. The section control unit then communicates with all of the meter terminal units 18 for customers who are served by that sub-station.

Commands or messages are transmitted from the section control units 14 over their associated power lines 24 preferably by means of carrier signals which are binary phase-modulated at thirty bits per second.

Generally, the meter terminal units 18 can be commanded to perform any of the following functions: reading and storing meter data, performing a reading of demand data and calculation of demand, transmitting previously stored meter or demand data, turning loads off and on, turning customer alerts on and off, and providing the status of external contacts.

The meter terminal units are individually addressable, group addressable, or block addressable. In each of the latter two cases, a number of meter terminal units are simultaneously addressed, and simultaneously respond to the commands.

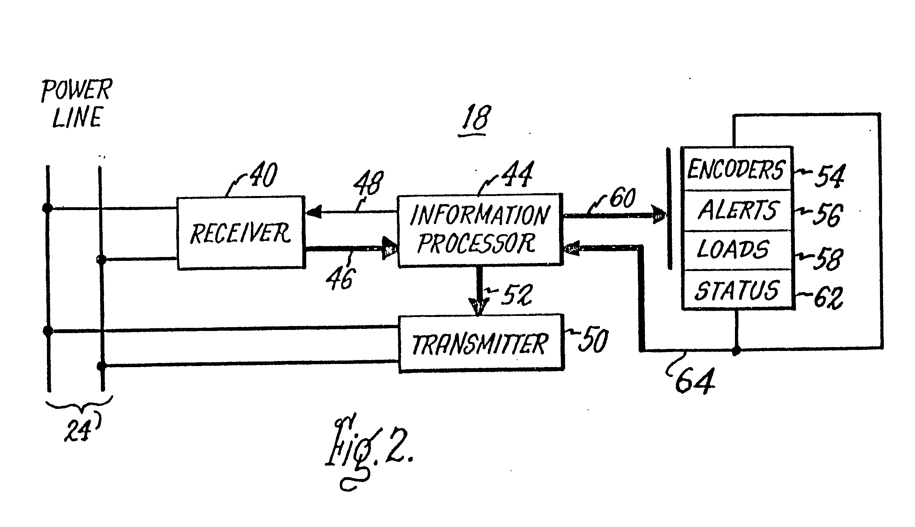

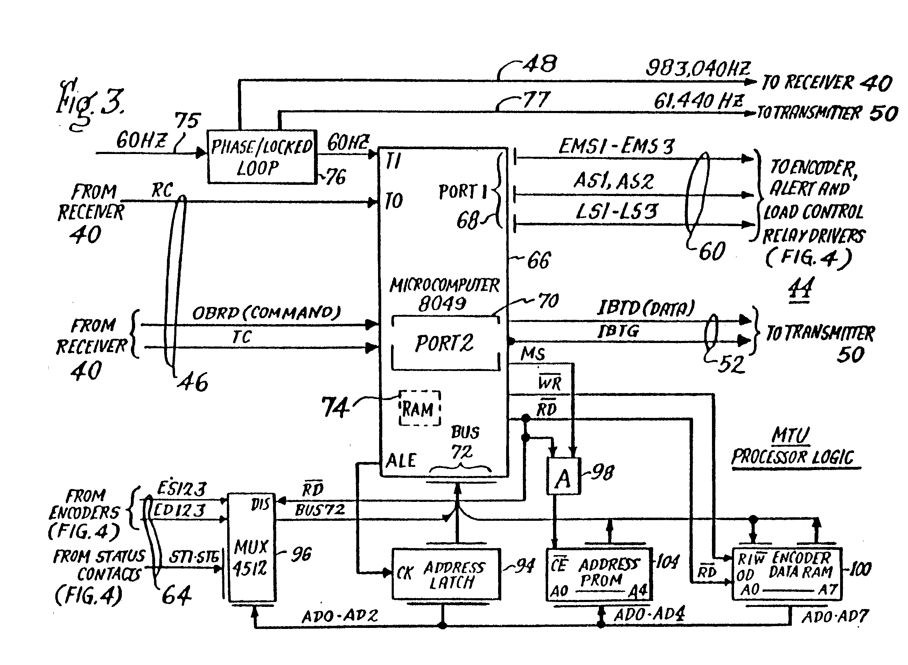

Fig. 2 is a simplified schematic diagram of the meter terminal unit 18 of the present invention. The meter terminal unit includes a receiver 40 which is connected to the power line 24. Signals received by the receiver 40 from the section control unit 14 of Fig. 1 over the power line 24 are transmitted on connections 46 to an information processor 44. The receiver 40 receives clock signals from the information processor 44 over a line 48. The information processor 44 is sometimes referred to below as a decoding device or as "decode means".

Signals which are to be transmitted from information processor 44 back to the section control unit 14 of Fig. 1 are carried through a plurality of lines 52 to a transmitter 50 which is also connected to the power line 24.

The information processor 44 transmits signals over a plurality of lines indicated at 60 to a plurality of encoders 54, alert indicator devices 56, and load control devices 58. The information processor 44 also receives signals from the encoders 54 and from a plurality of status switches 62 over a plurality of lines 64. The alert devices 56 may be signal lamps to alert the customer, for instance, that he is operating in a peak demand period, so that he may voluntarily limit his loads to keep his costs down.

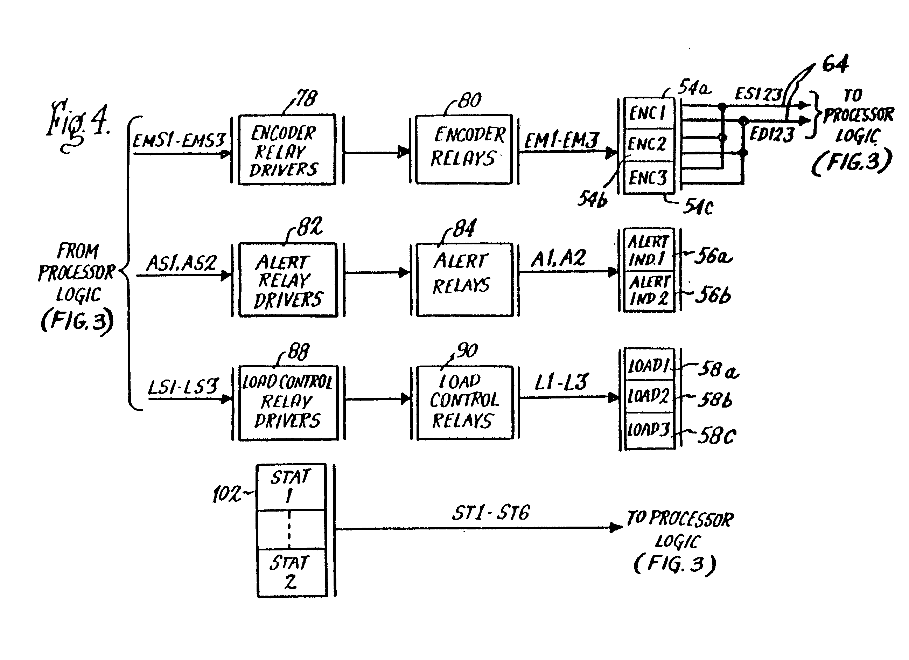

Fig. 3 is a more detailed schematic diagram of the information processor 44 of Fig. 2. The information processor preferably includes a microcomputer 66, which is preferably a microcomputer model 8049 which is available from Intel Corporation of Santa Clara, California, U.S.A.

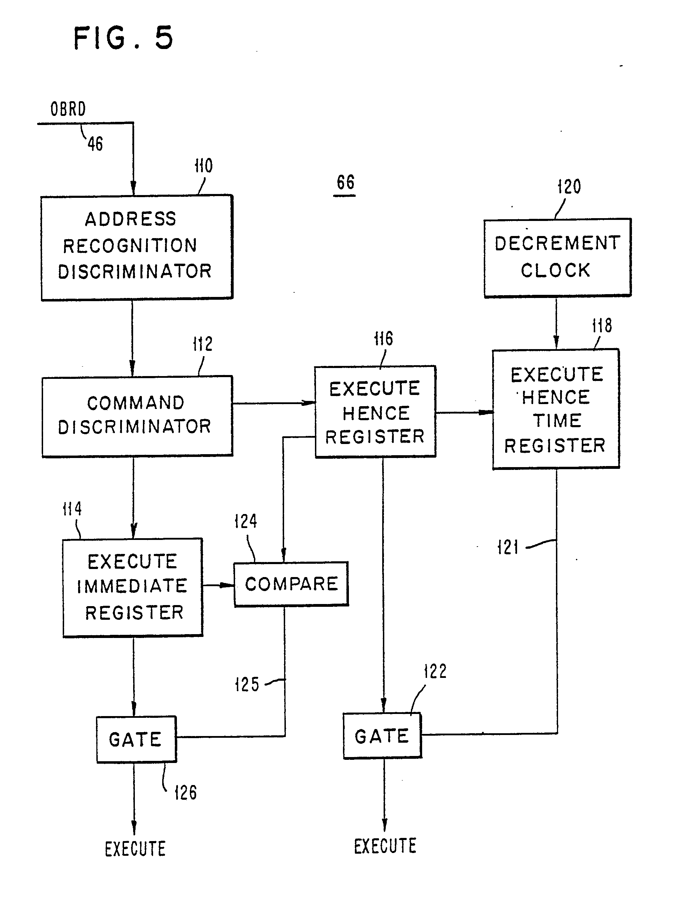

The micro-computer 66 incorporates a first eight bit port 68 through which signals are sent over the multiple lines 60 to the encoders 54, the alerts 56, and the loads 58, as previously described in connection with Fig. 2, and as shown and described in more detail in connection with Fig. 4 below.

Micro-computer 66 also includes a second eight bit port 70 through which most of the signals are received on the multiple connections 46 from receiver 40, as previously described in connection with Fig. 2, and through which information signals are supplied on the multiple connections 52 to the transmitter 50, as previously described in connection with Fig. 2. The connections 52 are further identified as IBTD (data) and IBTG. Connection IBTG is the gate connection.

One of the inputs 46 from the receiver 40 to the micro-processor 66 is supplied to the input terminal (TO) to provide a clock strobe (RC) from the receiver to the micro-processor so as to time the operation of the micro-processor in receiving data from the receiver 40 in connection with the data receiving function. The other connection labeled OBDR receives data containing commands.

The micro-computer 66 also includes an internal random access memory (RAM) 74 which is used in the course of various micro-computer operations for the storage of commands and data, as described more fully below.

The micro-computer 66 also includes an eight bit bi-directional port 72, which is also sometimes referred to as a bus, and by means of which the micro-computer communicates with a number of other associated memory and multiplex units 94, 96, 100, and 104.

A phase locked loop circuit 76 forms a part of the information processor circuit 44, and is arranged to operate in response to a 60 Hz input signal on connection 75 to provide a square wave 60 Hz timing signal at the T1 input of the microcomputer 66. The phase locked loop circuit 76 also provides a timing signal on connection 48 to receiver 40 which is at a frequency of 983,040 Hz. Similarly, the phase locked loop circuit provides a timing signal to transmitter 50 on a connection 77 at a frequency of 61,440 Hz.

Referring again to the port 68 from the micro-processor 66, the connections 60 are carried to the relay drivers shown in Fig. 4. Thus, the connections labeled EMS1 through EMS3 of Fig. 3 are carried to the encoder relay drivers 78 of Fig. 4 so that an individual signal on any one of these three connections will enable a corresponding one of the relay drivers 78. That corresponding relay driver will pick up an associated one of the encoder relays 80 to select one of the three meter encoders 54a, 54b, or 54c. In this manner, the encoders are individually activated. Similarly, signals on either of lines AS1 or AS2 activate one of the alert relay drivers 82 which selectively activate the alert relays 84 which selectively activate the alert indicator devices 56a or 56b. Also, the lines LS1 through LS3 of the set 60 from the micro-computer 66 in Fig. 3 activate selectively the individual load control relay drivers 88, controlling the associated individual load control relays 90 to selectively control the loads 58a, 58b, and 58c.

As a result of the enablement of any one of the encoders 54a, b, or c, meter reading data is generated which must be carried back to the micro-computer 66. This is accomplished over lines 64, which are individually labeled ES123 and ED123, and which are carried to a multiplex unit 96 in Fig. 3. Similarly, data on the status of status contact elements 102 is carried by signal lines ST1—ST6, which also comprise part of the connections 64, back to the multiplex unit 96 of Fig. 3. From the multiplex unit 96, such data is carried to the micro-processor on bus 72.

Data is read out of the multiplex circuit 96 through bus 72 to the micro-processor 60 in response to a read signal $\overline{RD}$ received from the micro-computer 66 and also in response to the concurrence of address control signals indicated at AD0—AD2 received from an address latch circuit 94. The control of the operation of the address latch circuit 94 is carried out by the micro-processor 66 by means of a connection to a clock input CK from an output ALE of the micro-processor 66.

By means of a connection to bus 72, data from the encoders 54 obtained through multiplex 96 is stored in an encoder data random access memory (RAM) 100. The data stored in the random access memory 100 may be addressed for read out by the eight addresses designated AD0 to AD7 which may be obtained from the address latch circuit 94. Memory 100 is further controlled by a connection to receive the read signal $\overline{RD}$, previously referred to above, or a write signal $\overline{WR}$, both emanating from the micro-processor 66.

The information processor 44 also includes an address programmable read only memory (PROM) 104 which is addressable by signal bits AD0 through AD4 from the address latch 94 when enabled by a signal from AND circuit 98. The AND circuit 98 is enabled upon the coincidence of a read signal $\overline{RD}$ and a memory strobe signal (MS) from the micro-computer 66. Fig. 5 is a functional block diagram illustrating a system combination of logical component circuits which can be employed for the purpose of carrying out the invention. However, in the preferred embodiment, these components are preferably entirely embodied in the micro-computer 66 of Fig. 3. Accordingly, Fig. 5 is considered to be a functional representation of a part of the micro-computer 66. However, it will be understood that all of the elements which are represented as discrete elements in Fig. 5 do not necessarily exist as discrete elements in the micro-computer 66, although the functions of these discrete elements of Fig. 5 are clearly performed by the micro-computer 66. The functions of the micro-computer 66 (as a part of the information processor 44) are described immediately below by reference to Fig. 5 as though the functional elements illustrated in Fig. 5 all existed as discrete elements within processor 66.

Referring in detail to Fig. 5, the command signal OBRD received on one of the connections 46 is reviewed by an address recognition discriminator 110 to determine whether or not this particular terminal unit is being addressed by the command. If the address of the present terminal unit, or a group address for the group to which this terminal unit belongs, is not recognized, then the command goes no farther than the address recognition discriminator because the command is not to be carried out by this particular terminal unit. On the other hand, if the address is recognized as destined for this particular terminal unit, the command is passed on to the command discriminator 112.

The command discriminator 112 determines whether the command is an execute immediate command, or an execute hence command. If the command is an execute immediate command, it is stored in the execute immediate register 114. However, if it is an execute hence command, it is stored in the execute hence register 116. An execute immediate command calls for immediate execution of the command. An execute hence commande calls for execution of the specified command at a future time. The time for execution of the execute hence command is passed on to an execute hence time register 118. Register 118 preferably stores the execute hence time in terms of a time interval during which the system is to wait before execution of the execute hence command. This time storage is in the form of a number. The execute hence time register 118 is then provided with clock pulses from a decrement clock 120 which successively reduces the time interval number stored in the execute hence time register 118. When the register 118 is finally decremented to 0, it causes the emission of a gating signal on connection 121 to a gate 122 which gates the command through from the execute hence register 116 for actual execution.

The execute hence commands and the execute immediate commands are often issued in related pairs in which the execute hence command is for one operation, and the execute immediate command is for an opposite operation. For instance, in accordance with the preferred embodiment of the invention, a maximum demand measurement may be made over a measured interval of time. For such an operation, the execute hence command may command the termination of the demand measurement interval and the execute immediate command which is paired with that execute hence command may command the commencement of the demand measurement interval. In accordance with another preferred feature of the present invention, when paired execute hence and execute immediate commands are to be deealt with, the execute hence command is first received and stored by the terminal unit in the execute hence register 116. Later, the corresponding execute immediate command which commands the opposite operation is received and stored in the execute immediate register 114. The commands stored in the two registers 116 and 114 are then compared in a comparison circuit 124 to see if they indeed command opposite operations. If the comparison confirms this, then the compare circuit 124 issues a gating signal at 125 to a gate circuit 126 to permit the execute immediate command to be executed from the execute immediate register 114. Thus, in accordance with this preferred feature of the invention, the execute immediate command cannot be executed unless a corresponding opposite action command is already stored in the execute hence register 116.

It is preferred that the execute hence command be stored first so that the execute immediate command can be executed promptly when it is received by favorable comparison in the compare circuit 124.

Referring back to Fig. 3, all of the storage registers of Fig. 5 are preferably embodied within the random access memory 74 contained within the micro-computer 66, and the logical switching embodied in Fig. 5 is carried out by the logic circuits of micro-computer 66.

Summarizing the operation of the terminal unit of the preferred embodiment of the invention, the terminal unit is arranged for connection to a power line 24, as shown in Fig. 2, and includes a receiver 40 for receiving a command over that power line. The command is typically in digital pulse form. An information processor 44, which is sometimes referred to below as a "decode means", receives the command from the receiver over connections 46 and responds to the received command to affect the immediate execution of the function specified by the command in response to recognition of an address assigned to the terminal unit as specified by at least a portion of the contents of the command. The information processor 44 is shown in more detail in Fig. 3 as comprising a micro-computer 66, which is functionally illustrated, in part, in Fig. 5. The address recognition function is carried out by the address recognition discriminator 110 of Fig. 5. It is an especially important feature of this invention however that the information processor includes means, such as the command discriminator 112 of Fig. 5, to distinguish between an execute immediate command and an execute hence command, and to cause the immediate execution of a command only when that command is recognized as an execute immediate command. The information processor is further operable to affect the execution of the function specified by the command only at a specified future time in response to recognition at 112 of the command as an execute hence type of command. The future time of execution is specified by a time field portion of the command which is stored at the execute hence time register 118.

In accordance with the preferred embodiment of the invention, the time field portion of the contents of the execute hence command is in the form of a numerical value corresponding to a specified length of time, and the information processor includes a means such as the decrement clock 120 to decrement the storage value of the time field portion stored in the execute hence time register 118 at uniform time intervals. The processor is then operable to perform the function specified by the function portion of the command when the stored value of the time field portion stored in register 118 has been decremented to 0.

As previously mentioned above, in accordance with the present invention, the execute immediate and execute hence commands may be issued in related pairs calling for opposite functions. One of the pairs of opposite functions to be carried out by the execute hence command and the execute immediate command may consist of the "demand on" function and the "demand off" function. In accordance with still another preferred feature of the invention, the information processor 44 (Fig. 3) includes a plurality of function code identifiable storage devices which may be embodied in the encoder data random access memory 100. The micro-computer 66 is operable for measuring the difference in the measurement data obtained at the beginning and at the end of each "demand on" interval, and for comparing that difference to the largest difference obtained during a preceding "demand on" time interval. The larger of the two compared difference values is then stored in one position of the random access memory 100. In this manner, whenever a greater demand is measured than any demand previously measured, the new and greater demand is stored for future reference.

In accordance with another preferred feature of the invention, the pair of execute hence and execute immediate commands may relate to respectively turning on a load and turning off that load by control of the load control relay drivers 88 and the load control relays 90 of Fig. 4, as previously mentioned above.

In accordance with another preferred feature of the invention, the information processor 44, Fig. 3, is operable to respond to a command to transfer data from the status devices 102 (Fig. 4), or from the encoders 54 Fig. 4 to memory storage, such as the random access memory 100 (Fig. 3) or the internal random access memory 74 (Fig. 3), and then to transfer that data from the memory to the transmitter 50 of Fig. 2 for transmitting the measurement data over the power line 24.

## Claims

1. A terminal unit (18, Fig. 2) for an automatic meter reading system, said terminal unit being arranged for connection to a power line (24) and comprising means (40) for receiving a command over the power line, decode means (44) responsive to the received command to effect the immediate execution of the function specified by the command in response to recognition (at 110, Fig. 5) of an address assigned to said terminal unit as specified by at least a portion of the contents of the command; characterized by the provision that said decode means comprises an information processor (44, Fig. 3) including means (66, Fig. 3; 112, Fig. 5) to distinguish between an execute immediate command and an execute hence command and to cause the immediate execution of a command only when that command is recognized as an execute immediate command, and further characterized by the provision that said information processor (44, Fig. 3) is operable to effect the execution of the function specified by the command only at a specified future time in response to recognition (at 112, Fig. 5) of the command as an execute hence type of command in combination with recognition (at 110) of an address assigned to said terminal unit as specified by an address portion of the command, said time of execution being specified by a time field portion (stored at 118) of said command.

2. A terminal unit as claimed in claim 1 further characterized in that said information processor (44, Fig. 2; 66, Fig. 3) includes means (116, Fig. 5) to store the function portion of the execute hence command, and further characterized in that the time field portion of the contents of the execute hence command contains a numerical value corresponding to a specified length of time, said information processor (44, Fig. 2; 66, Fig. 3) including means (74, Fig. 3; 118, Fig. 5) to store said time field portion and being operable to decrement (at 120) the stored value of said time field portion at predetermined time intervals; said information processor then being operable (at 122) to perform the function specified by the stored contents (at 116) of the function portion of the command when the stored value of the time field portion (at 118) has been decremented to zero.

3. A terminal unit as claimed in claim 1 further characterized in that said information processor (44, Fig. 3) is first operable to receive and store (at 74, Fig. 3; 116, Fig. 5) the command containing the execute hence type of address, said processor then being operable to receive and store (at 74, Fig. 3; 114, Fig. 5) the execute immediate command having a function code portion and an action field portion, said last-mentioned function code portion containing a specified function to be performed which is an opposite of the function specified in the execute hence command, said processor being operable to compare (at 124, Fig. 5) the functions specified in the execute immediate (at 114) and execute hence (at 116) commands and to perform (at 126) the function specified in the function code portion of the execute immediate command (at 114) only if the execute hence command containing the opposite function has been previously received and stored (at 116) for later execution at the expiration of said specified time interval.

4. A terminal unit (18, Fig. 2) as claimed in claim 1, claim 2 or claim 3 further characterized in the provision of means (54) for measuring demand over a predetermined interval of time, and further characterized in that the execute hence command relates to the specified function of turning off the demand function, and the execute immediate command function which is opposite in sense to the execute hence command calls for the "demand on" function.

5. A terminal unit as claimed in claim 4 further characterized in the provision of a plurality of function code identifiable storage means (100, Fig. 3), means (66, 74) for measuring the difference of measurement data obtained at the beginning and at the end of each "demand on" interval and for comparing that difference to the largest difference obtained during a preceding "demand on" time interval, the larger of the two compared difference values being stored in an identified one of said storage means.

6. A terminal unit as claimed in any one of claims 1, 2 or 3 further characterized in the provision of means (66, Fig. 3; 82, 84, Fig. 4) for controlling a load, and further characterized in that the execute hence command relates to the specified function of turning on the load, and the execute immediate command function which is opposite in sense to the execute hence command turns off the load.

7. A terminal unit as claimed in claim 6 further characterized in the provision of at least one alert control means (66, 68, Fig. 3; 82, 84, Fig. 4) for controlling an alert device associated therewith; and further characterized in that said processor operates in response to a unique function code type contained in the function code portion of a received command to selectively activate an identified one of said alert control means to effect the turning on of the alert device (56a, 56b, Fig. 4) associated therewith; and further characterized in that said processor operates in response to still another function code type contained in the function code portion of a received command to selectively activate an identified one of said alert control means to effect the turning off of the alert device associated therewith.

8. A terminal unit as claimed in claim 6 further characterized in the provision of at least one status means (102, Fig. 4) for monitoring the status of a switch associated therewith; further characterized in the provision of a multiple position storage means (74, Fig. 3) and still further characterized in that said processor (44, Fig. 3) operates in response to a unique function code type contained in the function code portion of a received command to selectively affect the storage of a signal from said status means (102) into an identified position of said storage means (74) as an indication of switch status; and further characterized in that said processor operates to affect the transfer of said switch status signal from said storage means (74) to transmitter means (50, Fig. 2) for transmitting said measurement data over said power line (24).

**Patentansprüche**

1. Anschlußeinheit (18, Fig. 2) für eine automatisches Meßgeräte-Ablesesystem, die für eine Verbindung mit einer Netzleitung (24) angeordnet ist und eine Einrichtung (40) zum Empfangen eines Befehls über die Netzleitung und eine auf den empfangenen Befehl ansprechende Dekodiereinrichtung (44) aufweist zum sofortigen Ausführen der durch den Befehl angegebenen Funktion beim Erkennen (bei 110 in Fig. 5) einer der Anschlußeinheit zugeordneten Adresse, wie sie durch wenigstens einen Teil des Inhalts des Befehls angegeben ist, dadurch gekennzeichnet, daß die Dekodiereinrichtung (44) einen Informationsprozessor (44 in Fig. 3) mit Mitteln (66 in Fig. 3; 112 in Fig. 5) aufweist zum Unterscheiden zwischen einem Sofort-Ausführbefehl und einem Danach-Ausführbefehl und zum Herbeiführen der sofortigen Ausführung eines Befehls nur dann, wenn dieser Befehl als ein Sofort-Ausführbefehl erkannt wird, und daß ferner der Informationsprozessor (44 in Fig. 3) die Ausführung der durch den Befehl angegebenen Funktion nur zu einer angegebenen zukünftigen Zeit veranlaßt bei Erkennen (bei 112 in Fig. 5) des Befehls als einen Danach-Ausführbefehl in Verbindung mit dem Erkennen (bei 110) einer der Anschlußeinheit zugeordneten Adresse, wie sie durch einen Adreßabschnitt des Befehls angegeben ist, wobei die Ausführungszeit durch einen Zeitfeldabschnitt (gespeichert bei 118) des Befehls angegeben ist.

2. Einheit nach Anspruch 1, dadurch gekennzeichnet, daß der Informationsprozessor (44 in Fig. 2; 66 in Fig. 3) Mittel (116 in Fig. 5) aufweist zum Speichern des Funktionsabschnitts des Danach-Ausführbefehls, und daß der Zeitfeldabschnitt des Inhalts des Danach-Ausführbefehls einen numerischen Wert enthält, der einer angegebenen Zeitlänge entspricht, wobei der Informationsprozessor (44 in Fig. 2; 66 in Fig. 3) Mittel (74 in Fig. 3; 118 in Fig. 5) aufweist zum Speichern des Zeitfeldabschnittes und den gespeicherten Wert des Zeitfeldabschnitts bei vorbestimmten Zeitintervallen dekrementieren kann (bei 120), und wobei der Information prozessor die Funktion, die durch den gespeicherten Inhalt (bei 116) des Funktionsabschnitts des Befehls angegeben ist, ausführen kann, wenn der gespeicherte Wert des Zeitfeldabschnitts (bei 118) auf null dekrementiert worden ist.

3. Anschlußeinheit nach Anspruch 1, dadurch gekennzeichnet, daß der Informationsprozessor (44 in Fig. 3) zunächst betätigbar ist zum Empfangen und Speichern (bei 74 in Fig. 3; 116 in Fig. 5) des Befehls, der den Danach-Ausführtyp der Adresse enthält, der Prozessor dann betätigbar ist zum Empfangen und Speichern (bei 74 in Fig. 3; 114 in Fig. 5) des Sofort-Ausführbefehls mit einem Funktionskodeabschnitt und einem Aktionsfeldabschnitt, wobei der letztgenannte Funktionskodeabschnitt eine angegebene, auszuführende Funktion enthält, die ein Gegensatz der in dem Danach-Ausführbefehl angegebenen Funktion ist, und daß der Prozessor betätigbar ist zum Vergleichen (bei 124 in Fig. 5) der in den Sofort-Ausführ- (bei 114) und Danach-Ausführbefehlen (116) angegebenen Funktionen und zum Ausführen (bei 126) der in dem Funktionskodeabschnitt des Sofort-Ausführbefehls (bei 114) angegebenen Funktion nur dann, wenn der die entgegengesetzte Funktion enthaltende Danach-Ausführbefehl zuvor empfangen und gespeichert ist (bei 116) für eine spätere Ausführung bei Ablauf des angegebenen Zeitintervalls.

4. Anschlußeinheit (18 in Fig. 2) nach Anspruch 1, Anspruch 2 oder Anspruch 3, gekennzeichnet, durch Mittel (54) zur Bedarfsmessung über einem vorbestimmten Zeitintervall, wobei der Danach-Ausführbefehl zu der angegebenen Funktion des Abschaltens der Bedarfsfunktion in Beziehung steht und die Sofort-Ausführbefehlsfunktion, die einen entgegengesetzten Sinn zum Danach-Ausführbefehl hat, die "Bedarf-Ein-" Funktion anfordert.

5. Anschlußeinheit nach Anspruch 4, gekennzeichnet, durch mehrere Funktionskode-identifizierbare Speichereinrichtungen (100 in Fig. 3) mit Mitteln (66, 74) zum Messen der Differenz der Meßdaten, die zu Beginn und am Ende von jedem "Bedarf-Ein-"Intervall erhalten werden, und zum Vergleichen dieser Differenz mit der größten Differenz, die während eines verhergehenden "Bedarf-Ein-"Zeitintervalls erhalten wurde, wobei der größere der zwei verglichenen Differenzwerte an einer bestimmten Stelle der Speichereinrichtung gespeichert wird.

6. Anschlußeinheit nach einem der Ansprüche 1, 2 oder 3, gekennzeichnet, durch Mittel (66 in Figur 3; 82, 84 in Fig. 4) zum Steuern einer Last, wobei der Danach-Ausführbefehl sich auf die angegebene Funktion des Einschaltens der Last bezieht und die Sofort-Ausführbefehlsfunktion, die einen entgegengesetzten Sinn zu dem Danach-Ausführbefehl hat, die Last ausschaltet.

7. Anschlußeinheit nach Anspruch 6, dadurch gekennzeichnet, daß wenigstens eine Alarmsteuereinrichtung (66, 68 in Fig. 3; 82, 84 in Fig. 4) vorhanden ist zum Steuern einer zugeordneten Alarmvorrichtung, und daß der Prozessor bei einem bestimmten Funktionskodetyp, der in dem Funktionskodeabschnitt eines empfangenen Signals enthalten ist, eine bestimmte Alarmsteuereinrichtung selektiv betätigt zum Einschlaten der zugeordneten Alarmvorrichtung (56a, 56b in Fig. 4), und daß der Prozessor noch bei einem anderen Funktionskodetyp, der in dem Funktionskodeabschnitt eines empfangenen Befehls enthalten ist, eine bestimmte Alarmsteuereinrichtung selektiv betätigt zum Ausschalten der zugeordneten Alarmvorrichtung.

8. Anschlußeinheit nach Anspruch 6, dadurch gekennzeichnet, daß weiterhin wenigstens eine Statuseinrichtung (102 in Fig. 4) zum Überwachen des Status eines zugeordneten Schalters vorhanden ist und daß eine viele Positionen aufweisende Speichereinrichtung (74 in Fig. 3) vorgesehen ist und daß der Prozessor (44 in Fig. 3) bei einem bestimmten Funktionskodetyp, der in dem Funktionskodeabschnitt eines empfangenen Befehls enthalten ist, selektiv die Speicherung eines Signals von der Statuseinrichtung (102) in eine bestimmte Position der Speichereinrichtung (74) als eine Anzeige des Schalterstatus herbeiführt, und daß der Prozessor die Übertragung des Schalterstatussignals von der Speichereinrichtung (74) zur Sendereinrichtung (50 in Fig. 2) herbeiführt zum Senden der Maßdaten über die Meßleitung (24).

## Revendications

1. Un terminal (18, figure 2) pour un système automatique de relevé de compteurs, ce terminal étant conçu de façon à être connecté à une ligne d'énergie (24) et comprenant des moyens (40) destinés à recevoir un ordre par la ligne d'énergie, et des moyens de décodage (44) qui réagissent à l'ordre reçu en effectuant l'exécution immédiate de la fonction spécifiée par l'ordre, sous l'effet de la reconnaissance (en 110, figure 5) d'une adresse affectée au terminal, qui est spécifiée par une partie au moins du contenu de l'ordre; caractérisé par le fait que les moyens de décodage consistent en un dispositif de traitement d'information (44, figure 3) comprenant des moyens (66, figure 3; 112, figure 5) destinés à distinguer entre un ordre à exécution immédiate et un ordre à exécution différée, et à provoquer l'exécution immédiate d'un ordre uniquement lorsque cet ordre est reconnue comme étant un ordre à exécution immédiate, et caractérisé en outre par le fait que le dispositif de traitement d'informatin (44, figure 3) peut fonctionner de façon à exécuter la fonction spécifiée par l'ordre uniquement à un instant futur spécifié, sous l'effet de la reconnaissance (en 112, figure 5) de l'ordre comme étant un ordre du type à exécution différée, en combinaison avec la reconnaissance (en 110) d'une adresse affectée au terminal considéré, qui est spécifiée par une partie d'adresse de l'ordre, l'instant d'exécution étant spécifié par une partie de zone d'instant (enregistrée en 118) de l'ordre.

2. Un terminal selon la revendication 1, caractérisé en outre en ce que le dispositif de traitement d'information (44, figure 2; 66, figure 3) comprend des moyens (116, figure 5) destinés à enregistrer la partie de fonction de l'ordre à exécution différée, et caractérisé en outre en ce que la partie de zone d'instant du contenu de l'ordre à exécution différée contient une valeur numérique qui correspond à une durée spécifiée, le dispositif de traitement d'information (44, figure 2; 66, figure 3) comprend des moyens (74, figure 3; 118, figure 5) destinés à enregistrer la partie de zone d'instant, et il peut fonctionner de façon à décrémenter (en 120), à des intervalles de temps prédéterminés, la valeur enregistrée de la partie de zone d'instant; et le dispositif de traitement d'information peut ensuite fonctionner (en 122) de façon à accomplir la fonction qui est spécifiée par le contenu enregistré (en 116) de la partie de fonction de l'ordre, lorsque la valeur enregistrée de la partie de zone d'instant (en 118) a été décrémentée jusqu'à zéro.

3. Un terminal selon la revendication 1, caractérisé en outre en ce que le dispositif de traitement d'information (44, figure 3) peut fonctionner tout d'abord de façon à recevoir et à enregistrer (en 74, figure 3; 116, figure 5) l'ordre contenant l'adresse du type à exécution différée, puis le dispositif de traitement peut fonctionner de façon à recevoir et à enregistrer (en 74, figure 3; 114, figure 5) l'ordre à exécution immédiate ayant une partie de code de fonction et une partie de zone d'action, la partie de code de fonction mentionnée en dernier contenant une fonction spécifiée à accomplir, qui est opposée à la fonction spécifiée dans l'ordre à exécution différée, le dispositif de traitement pouvant fonctionner de façon à comparer (en 124, figure 5) les fonctions spécifiées dans les ordres à exécution immédiate (en 114) et à exécution différée (en 116) et à accomplir (en 126) la fonction spécifiée dans la partie de code de fonction de l'ordre à exécution immédiate (en 114), uniquement si l'ordre à exécution différée contenant la fonction opposée a été reçu enregistré précédemment (en 116) pour une exécution ultérieure à l'expiration de l'intervalle de temps spécifié.

4. Un terminal (18, figure 2) selon la revendication 1, la revendication 2 ou la revendication 3, caractérisé en outre par l'existence de moyens (54) destinées à mesurer une consommation instantanée sur un intervalle de temps prédéterminé, et caractérisé en outre en ce que l'ordre à exécution différée concerne la fonction spécifiée qui est d'arrêter la fonction de mesure de consommation instantanée, et la fonction de l'ordre à exécution immédiate qui est de sens opposé à l'ordre à exécution différée demande l'exécution de la fonction "consommation instantanée".

5. Un terminal selon la revendication 4, caractérisé en outre en ce qu'il comprend un ensemble de moyens d'enregistrement identifiables par un code de fonction (100, figure 3), et des moyens (66, 74) destinés à mesurer la différence entre des données de mesure obtenues au début et à la fin de chaque intervalle de "consommation instantanée", et à comparer cette différence avec la plus grande différence obtenue au cours d'un intervalle de temps de "consommation instantanée" précédent, la plus grande des deux valeurs de différence comparées étant enregistrée dans l'un des moyens d'enregistrement qui est identifié.

6. Un terminal selon l'une quelconque des revendications 1, 2 ou 3, caractérisé en outre en ce qu'il comprend des moyens (66, figure 3; 82, 84, figure 4) destinés à commander une charge, et caractérisé en outre en ce que l'ordre à exécution différée concerne la fonction spécifiée consistant à mettre la charge en fonction, et la fonction d'ordre à exécution immédiate qui est de sens opposé à l'ordre à exécution différée met la charge hors fonction.

7. Un terminal selon la revendication 6, caractérisé en outre en ce qu'il comprend au moins un élément de commande de signalisation (66, 68, figure 3; 82, 84, figure 4) destiné à commander un dispositif de signalisation associée; et caractérisé en outre en ce que le dispositif de traitement fonctionne sous la dépendance d'un type particulier de code de fonction contenu dans la partie de code de fonction d'un ordre reçu, en actionnant sélectivement l'un des éléments de commande de signalisation qui est identifié, pour mettre en fonction le dispositif de signalisation (56a, 56b, figure 4) qui lui est associé; et caractérisé en outre en ce que le dispositif de traitement fonctionne sous la dépendance d'un autre type de code de fonction contenu dans la partie de code de fonction d'un ordre reçu, de façon à actionner sélectivement l'un des éléments de commande de signalisation qui est identifié, pour mettre hors fonction le dispositif de signalisation qui lui est associé.

8. Un terminal selon la revendication 6, caractérisé en outre en ce qu'il comprend au moins un élément d'indication d'état (102, figure 4) destiné à contrôler l'état d'un contact qui lui est associée; caractérisé en outre en ce qu'il comprend des moyens d'enregistrement à positions multiples (74, figure 3) et caractérisé en outre en ce que le dispositif de traitement (44, figure 3) fonctionne sous la dépendance d'un type particulier de code de fonction contenu dans la partie de code de fonction d'un ordre reçu, de façon à enregistrer sélectivement un signal provenant des éléments d'indication d'état (102) dans une position identifiée des moyens d'enregistrement (74), à titre d'indication de l'état d'un contact; et caractérisé en outre en ce que le dispositif de traitement fonctionne de façon à transférer le signal d'état de contact des moyens d'enregistrement (74) vers des moyens émetteurs (50, figure 2), pour émettre les données de mesure par la ligne d'énergie (24).

**Fig.1.**

RCC

COMPUTER — 26

— 12

CIU — 28

MOD. — 30

— 16

MOD. — 30

XMIT/RCV SCU — 14

**10**

— 24

MTU — 18

18 — MTU

M M M — 54 — M M M

| L | L | L | A | A |
|---|---|---|---|---|

58 — — 56

| L | L | L | A | A |
|---|---|---|---|---|

58 — — 56

POWER LINE

RECEIVER 40

48

18

INFORMATION PROCESSOR 44

60

ENCODERS ~54
ALERTS ~56
LOADS ~58
STATUS ~62

46

52

TRANSMITTER ~50

64

24

Fig. 2.

0 049 276

Fig. 3.

0 049 276

Fig. 4.

FROM PROCESSOR LOGIC (FIG. 3)

EMS1-EMS3 → ENCODER RELAY DRIVERS (78) → ENCODER RELAYS (80) → EM1-EM3 → ENC1 (54a), ENC2 (54b), ENC3 (54c) → ES123, ED123 → 64 → TO PROCESSOR LOGIC (FIG. 3)

AS1,AS2 → ALERT RELAY DRIVERS (82) → ALERT RELAYS (84) → A1,A2 → ALERT IND. 1 (56a), ALERT IND. 2 (56b)

LS1-LS3 → LOAD CONTROL RELAY DRIVERS (88) → LOAD CONTROL RELAYS (90) → L1-L3 → LOAD1 (58a), LOAD2 (58b), LOAD3 (58c)

102 → STAT 1 ... STAT 2 → ST1-ST6 → TO PROCESSOR LOGIC (FIG. 3)

0 049 276

4

# FIG. 5

OBRD
46

ADDRESS
RECOGNITION
DISCRIMINATOR
110

66

DECREMENT
CLOCK
120

COMMAND
DISCRIMINATOR
112

EXECUTE
HENCE
REGISTER
116

EXECUTE
HENCE
TIME
REGISTER
118

EXECUTE
IMMEDIATE
REGISTER
114

COMPARE
124

121

125

122

GATE
126

GATE

EXECUTE

EXECUTE